# EUROPEAN PATENT APPLICATION

(11) **EP 2 383 872 A2**
(43) Date of publication of application: **02.11.2011**
(21) Application number: 11163973.8
(22) Date of filing: 27.04.2011
(51) Int. Cl.: H02K 11/00, G01R 31/327

(54) **Fault detection device and method for detecting an electrical fault**

(30) Priority: 30.04.2010 US 770918
(71) Applicant: General Electric Company, Schenectady, NY 12345 (US)
(72) Inventor: Barton, Werner, 48712, Gescher (DE)
(74) Representative: Bedford, Grant Richard

(57) **Abstract**

A fault detection device adapted for detecting an electrical fault at a medium voltage switchgear (200) having at least one power module (201, 202, 203) is provided. The fault detection device includes at least one input current sensor (301, 302, 303) adapted for measuring at least one input current (501, 502, 503) of the at least one power module (201, 202, 203) of the medium voltage switchgear (200) and at least one output current sensor (400, 401, 402, 403) adapted for measuring at least one output current (600, 601, 602, 603) of the at least one power module (201, 202, 203) of the medium voltage switchgear (200). A comparator (405) is provided which is adapted for comparing the at least one output current (600, 601, 602, 603) with the at least one input current (501, 502, 503). A control unit (406) is adapted for determining an electrical fault at the at least one power module (201, 202, 203) of the medium voltage switchgear (200) on the basis of the comparison.

## Description

The present disclosure generally relates to a detection of electrical faults in electrical devices, and in particular relates to a method for detecting an electrical fault in electrical and/or electronic components of a wind turbine. Furthermore, the present disclosure relates to a fault detection device adapted for detecting a fault in electrical or electronic components.

Wind turbines are of increasing importance as environmentally safe and reliable energy sources. A wind turbine typically includes a rotor having at least one rotor blade and a hub for converting incoming wind energy into rotational, mechanical energy. A rotation of the hub of the wind turbine is transferred to a main rotor shaft which drives, with or without a gearbox inbetween, an electrical generator. The electrical generator is adapted for converting the mechanical rotational energy into electrical energy. Electrical components connected to the electrical generator may include current transformers, power converters, switchgears or other electrical distribution systems.

In case e.g. a short circuit, an open circuit, a ground fault etc. occurs within the electrical and/or electronic part of the wind turbine, problems may arise with respect to wind turbine maintenance and wind turbine reliability. The electrical/electronic components installed at a wind turbine may be protected by fuses for only few specific electrical faults.

There is, however, a plurality of faults which may degrade the operability of a wind turbine, wherein some of the faults cannot be eliminated by installation of appropriate fuses. Rather, the electrical / electronic components may be monitored during an operation of the wind turbine. Electronic components of the wind turbine may include switchgears for electrical power distribution, the switchgears including a plurality of power modules. These power modules include semiconductor components (e.g. IGBT, "insulated gate bipolar transistor") which are sensitive to overvoltages. Electrical faults which may occur within these devices may typically include an open circuit, a short circuit, a ground fault, an insulation fault, a low-arc flash-based current and electrical arcs. For a reliable operation of wind turbines with respect to their electrical and/or electronic components, a continuous monitoring of these components with respect to the electrical faults mentioned above is an important issue.

In view of the above according to an aspect of the present invention, a fault detection device adapted for detecting an electrical fault at a medium voltage switchgear having at least one power module is provided, the fault detection device including at least one input current sensor adapted for measuring at least one input current of the at least one power module of the medium voltage switchgear, at least one output current sensor adapted for measuring at least one output current of the at least one power module of the medium voltage switchgear, a comparator adapted for comparing the at least one output current with the at least one input current, and a control unit adapted for determining an electrical fault at the at least one power module of the medium voltage switchgear on the basis of the comparison.

According to another aspect a wind turbine having an electrical generator adapted for converting mechanical energy into electrical energy, a medium voltage switchgear and a fault detection device adapted for detecting an electrical fault at the medium voltage switchgear is provided, the fault detection device including at least one input current sensor adapted for measuring at least one input current of the at least one power module of the medium voltage switchgear, at least one output current sensor adapted for measuring at least one output current of the at least one power module of the medium voltage switchgear, a comparator adapted for comparing the at least one output current with the at least one input current, and a control unit adapted for determining an electrical fault at the at least one power module of the medium voltage switchgear from the comparison.

According to yet another aspect a method for detecting an electrical fault at a medium voltage switchgear having at least one power module is provided, the method including the steps of measuring at least one input current of the at least one power module of the medium voltage switchgear, measuring at least one output current of the at least one power module of the medium voltage switchgear, comparing the at least one output current with the at least one input current, and determining an electrical fault at the medium voltage switchgear from the comparison.

Further exemplary embodiments are according to the dependent claims, the description and the accompanying drawings.

Various aspects and embodiments of the present invention will now be described in connection with the accompanying drawings, in which:
Fig. 1 shows a side view of a wind turbine having an electrical generator for converting mechanical rotational energy into electrical energy, according to a typical embodiment;
Fig. 2 illustrates a machine nacelle of a wind turbine, wherein the machine nacelle includes a gearbox, an electrical generator and a medium voltage switchgear;
Fig. 3 illustrates an electrical connection between an electrical generator of the wind turbine to a main transformer of the wind turbine via a medium voltage switchgear, according to a typical embodiment;
Fig. 4 shows the electrical arrangement shown in Fig. 4 wherein a distribution panel unit is connected between the medium voltage switchgear and the main transformer;
Fig. 5 details an internal set-up of medium voltage switchgear having three power modules and respective input and output sensors, according to a typical embodiment;
Fig. 6 is a block diagram illustrating a generation of a control signal on the basis of measured input and output currents of individual power modules of a medium voltage switchgear, according to a typical embodiment;
Fig. 7 is a block diagram illustrating components of a fault detection device for detecting a fault within electrical and/or electronic components of a wind turbine and for generating a control signal, according to another typical embodiment; and
Fig. 8 is a flowchart illustrating a method for detecting an electrical fault within a medium voltage switchgear having at least one power module, according to yet another typical embodiment.

Reference will now be made in detail to the various exemplary embodiments, one or more examples of which are illustrated in the drawings. Each example is provided by way of explanation and is not meant as a limitation. For example, features illustrated or described as part of one embodiment can be used on or in conjunction with other embodiments to yield yet a further embodiment. It is intended that the present disclosure includes such modifications and variations.

A number of embodiments will be explained below. In this case, identical structural features are identified by identical reference symbols in the drawings. The structures shown in the drawings are not depicted true to scale but rather serve only for the better understanding of the embodiments.

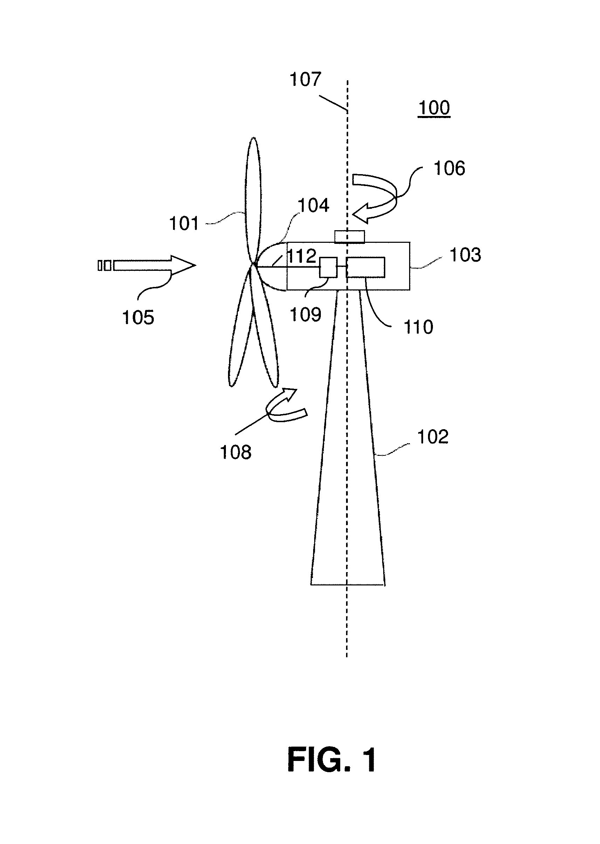

Fig. 1 is a side view of a wind turbine 100 according to a typical embodiment. The wind turbine includes a machine nacelle 103 which is mounted rotatably atop a tower 102. The machine nacelle 103 may be rotated about a vertical tower axis 107 (broken line) such that the machine nacelle 103 may be directed with respect to the incoming wind direction 105.

Typically, a main shaft 112 of a rotor of the wind turbine 100 coincides with the incoming wind direction 105. To this end, a yaw angle 106 may be adjusted by a yaw angle adjustment unit (not shown in Fig. 1). The rotor of the wind turbine 100 includes at least one rotor blade 101 for converting the wind energy of the incoming wind 105 into mechanical rotational energy.

In order to adapt a rotational frequency of the main shaft 112 to the velocity or strength of the incoming wind 105, a pitch angle 108 of an individual rotor blade 101 may be adjusted. The at least one rotor blade is connected to a hub 104 of the rotor and is rotatable about its longitudinal axis.

The main shaft 112 connects the hub 104 of the wind turbine 100 to a gearbox 109 which is used to adapt a rotational speed of the main shaft 112 to a rotational speed of an electrical generator 110 which follows the gearbox 109. The electrical generator 110 converts the mechanical rotational energy output from the gearbox 109 into electrical energy. The components following the electrical generator 110 are mainly electrical and/or electronic components which are not shown in Fig. 1, but which will be described herein below.

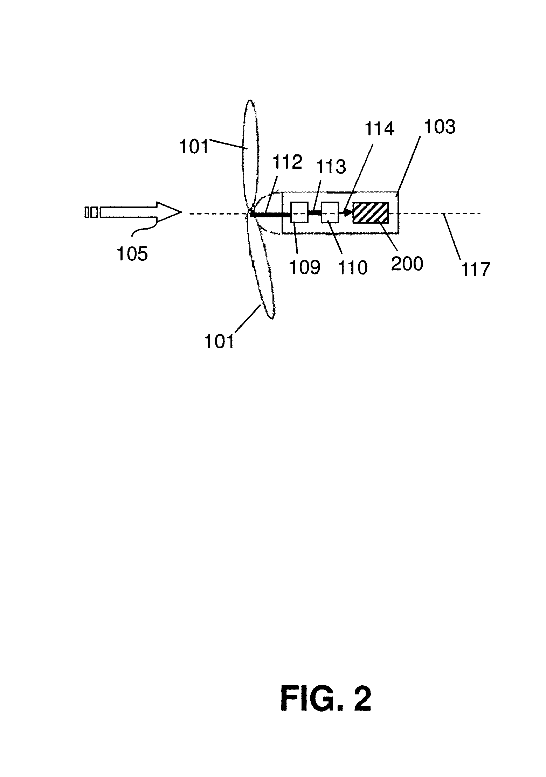

Fig. 2 is a schematic view of the machine nacelle 103 of the wind turbine 100, wherein components arranged along a rotor axis 117 of the rotor of the wind turbine 100 are shown. The rotor axis 117 is oriented in a direction 105 of the incoming wind. The rotor blades 101 drive the hub 104 which in turn rotates the main shaft 112. The main shaft 112 is connected to a gearbox input shaft of the gearbox 109. A gearbox output shaft 113 of the gearbox 109 is connected to the electrical generator 110 which converts the mechanical rotational energy into electrical energy.

At the output of the electrical generator 110, an electrical connection 114 is provided which connects the electrical generator 110 to a medium voltage switchgear 200. Albeit the switchgear 200 is shown to be arranged within the machine nacelle 103, the switchgear 200 may be arranged at any other location within or nearby the wind turbine 100. Typically, a medium voltage switchgear is used in association with an electrical power system or grid. The electrical switchgear refers to a combination of electrical disconnects, fuses and/or circuit breakers. The switchgear may be manually or automatically operated.

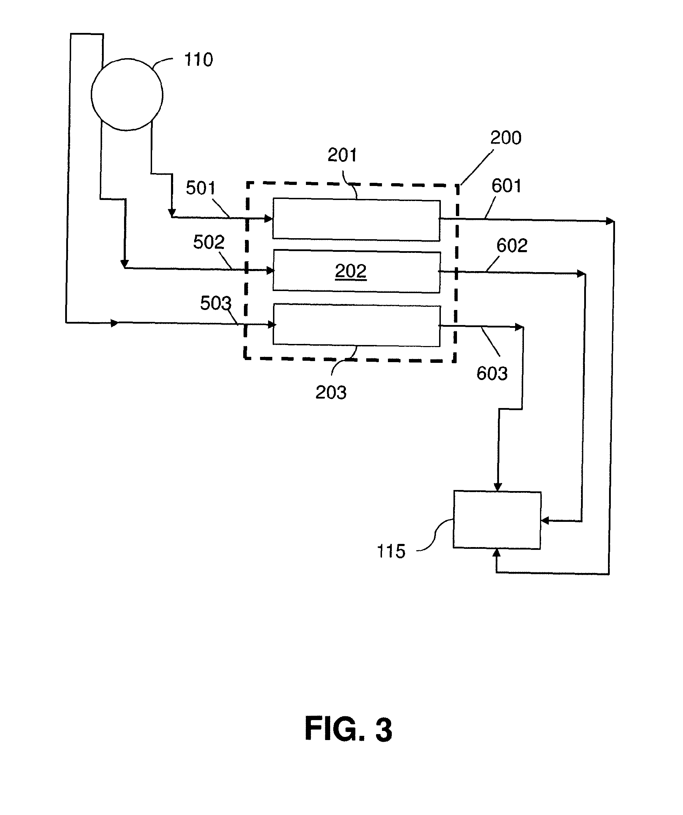

Fig. 3 illustrates a typical electrical connection arrangement between an electrical generator 110 of a wind turbine and a main transformer 115 of the wind turbine. As shown in Fig. 3, a medium voltage switchgear 200 is connected between the electrical generator 110 and the main transformer 115. The electrical generator 110 illustrated in Fig. 3 provides three electrical phases such that the medium voltage switchgear 200 is designed to have a first power module 201 for a first phase, a second power module 202 for a second phase and a third power module 203 for a third phase.

Three input currents, i.e. a first input current 501 of the first power module 201, a second input current 502 of the second power module 202 and a third input current 503 of the third power module 203 are provided by the electrical generator 110. Output currents of the medium voltage switchgear 200 include a first output current 601 of the first power module 201, a second output current 602 of the second power module 202 and a third output current 603 of the third power module 203. The output currents are fed to the main transformer 115 of the wind turbine 100 in order to provide output energy to various electrical loads.

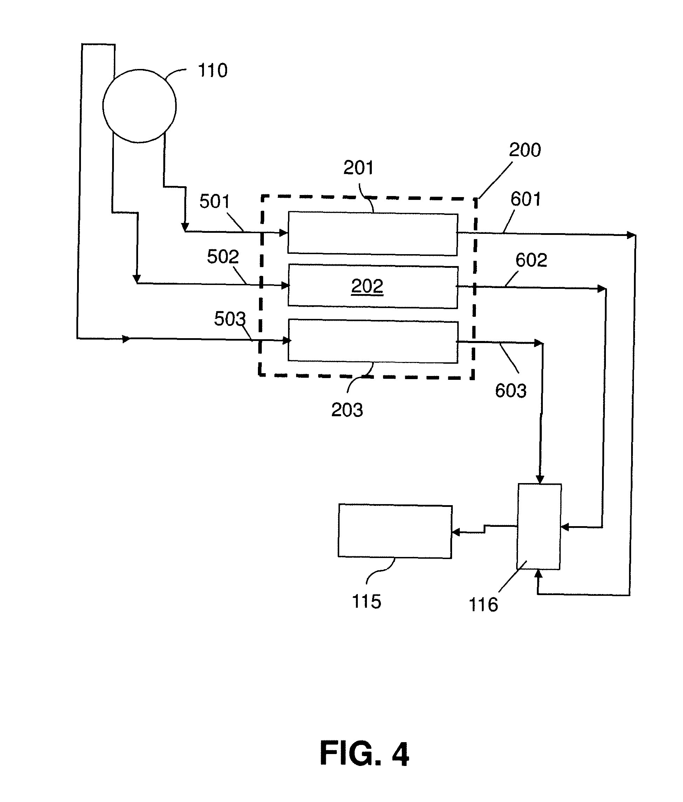

Fig. 4 is a block diagram illustrating an electrical generator 110 which is connected to a distribution panel unit 116 via a medium voltage switchgear 200. The medium voltage switchgear 200 includes a first power module 201, a second power module 202 and a third power module 203, i.e. three phases of electrical power provided by the electrical generator 110 can be processed within the medium voltage switchgear. The distribution panel unit 116 which receives the three phases is used to distribute at least a part of the electrical power to other electrical components within the medium voltage switchgear 200 or outside the medium voltage switchgear 200 before the electrical power is transferred to the main transformer 115. The lines with arrows indicated by reference numerals 501, 502, 503 and 601, 602, 603, respectively, indicate current paths carrying a respective supply current from the electrical generator 110 of the wind turbine 100 to the distribution panel unit 116.

As the medium voltage switchgear 200 includes three individual power modules, i.e. the first power module 201, the second power module 202 and the third power module 203, three input currents, i.e. a first input current 501, a second input current 502 and a third input current 503 are provided by the electrical generator 110 of the wind turbine 100. Furthermore, three output currents are provided by the three individual power modules 201, 202 and 203 of the medium voltage switchgear 200, i.e. the first output current 601 is provided by the first power module 201, the second output current 602 is provided by the second power module 202 and the third output current 603 is provided by the third power module 203.

If the primary and secondary sides of the medium voltage switchgear 200 operate at the same voltage level, the sum of the first, second and third input currents 501, 502 and 503 typically corresponds to the sum of the first, second and third output currents 601, 602 and 603. If, e.g. a short circuit occurs between the power modules 201, 202 and 203 always in the electronics of the power modules 201, 202 and 203, this situation might change. If a ground fault e.g. occurs at the third power module 203, the current balance is disturbed.

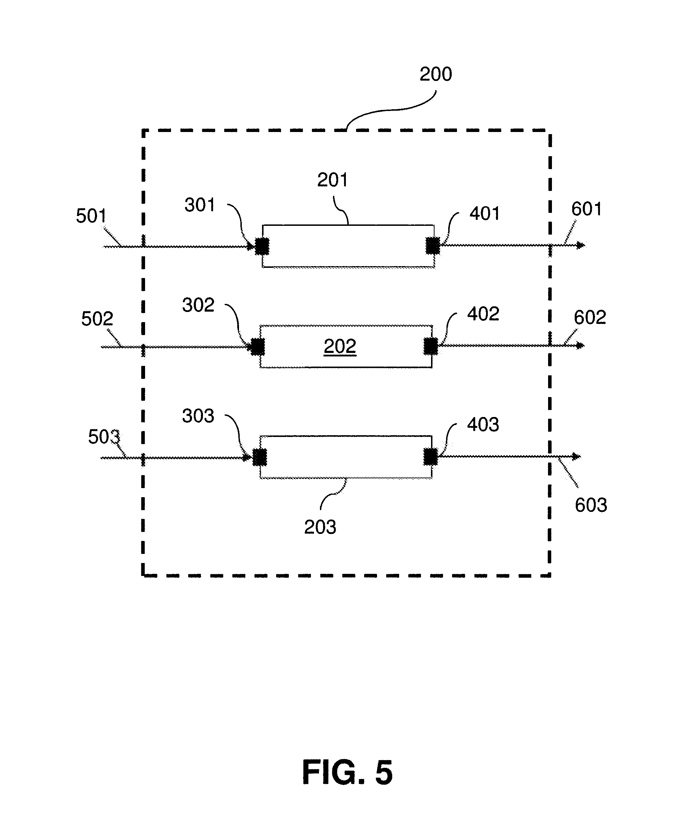

In accordance with a typical embodiment indicated herein below with respect to Fig. 5, a sum of input currents and a sum of output currents, respectively, is measured and compared to each other. If the sum of input currents does not correspond to the sum of output currents, it may be concluded that an electrical fault like an open circuit, a short circuit, a ground fault, an insulation fault, a low-arc flash-based current and an electrical arc may have occurred.

Fig. 5 is a more detailed block diagram of a medium voltage switchgear 200 in accordance with a typical embodiment. As before, the medium voltage switchgear 200 includes a first power module 201, a second power module 202 and a third power module 203, e.g. for providing a three-phase current for a load (not shown in Fig. 5). Furthermore, the electrical generator 110 of the wind turbine 100 is not shown in Fig. 5 in order to ease a detailed description of the other components.

As shown in Fig. 5, each of the first power module, second power module and third power module 201, 202 and 203 include input and output current sensors. I.e., the first power module 201 has a first input current sensor 301 and a first output current sensor 401, the second power module 202 has a second input current sensor 302 and a second output current sensor 402, and the third power module 203 has a third input current sensor 303 and a third output current sensor 403. The first, second and third input current sensors 301, 302 and 303 are provided to determine the first, second and third input currents 501, 502 and 503, respectively.

On the other hand, the first, second and third output current sensors 401, 402 and 403 provide a measurement signal indicating a measure of the first output current 601, the second output current 602 and the third output current 603, respectively. One current sensor at the input or output side of a power module 201, 202, 203, more than one current sensor or all current sensors may be provided as at least one of a Hall current sensor, a Faraday rotation sensor, a shunt, an inductive sensor and a current transformer.

If a Hall current sensor is provided, a respective input or output current is determined on the basis of a magnetic field generated by the respective input or output current. As the skilled person is familiar with the operation principle of Hall sensors, this kind of current sensing is not detailed here in order to provide a concise description.

If a Faraday rotation current sensor is provided, a respective input or output current is determined on the basis of a rotation of a polarized light beam propagating in an optical wave guide. A detected polarization rotation is then measured on the basis of the respective input or output current. As the skilled person is familiar with the operation principle of Faraday rotation current sensor, this kind of current sensing is not detailed here in order to provide a concise description.

Moreover, a shunt or shunt resistor may be used for input/output current sensing, wherein the current to be measured passes through the shunt resulting in a measurable voltage drop across the shunt.

The respective current sensors output a signal indicative of the respective input currents 501, 502 and 503 or the respective output current 601, 602 and 603. As can be seen from Fig. 5, the current sensors 301, 302, 303, 401, 402 and 403 may be accessible from outside the medium voltage switchgear 200 and the first, second and third power modules 201, 202, 203, respectively, such that input and output currents may be determined individually.

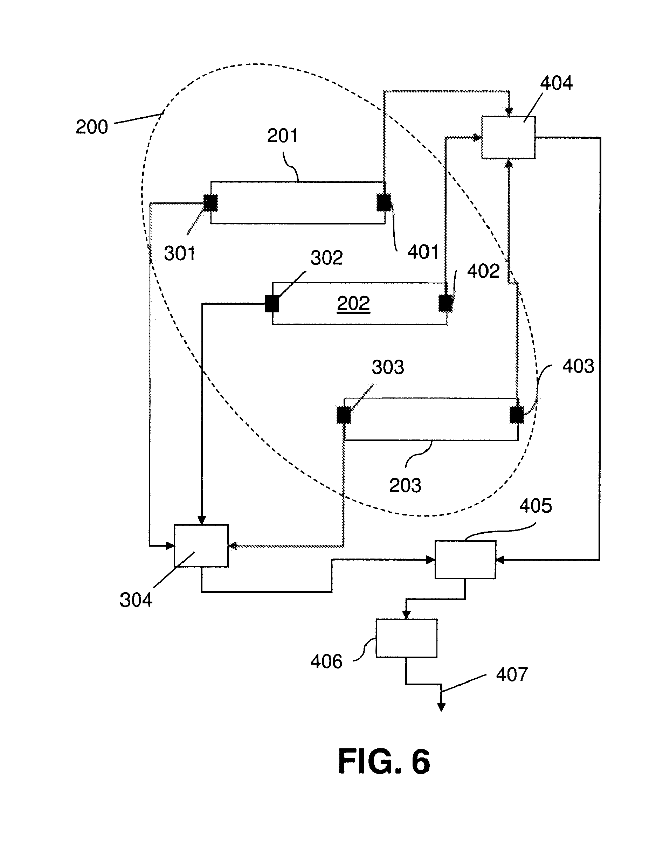

Based on a sensing of input and output currents at the medium voltage switchgears 200 and/or at individual power modules 201, 202 and 293, a fault detection device may be designed, a typical embodiment of which is illustrated in Fig. 6.

Again, a medium voltage switchgear 200 having a first power module 201, a second power module 202 and a third power module 203 is indicated by a dashed ellipse. It is noted here, in order to simplify the description, that current paths from the electrical generator 110 to an individual power module 201, 202 and 203 of the medium voltage switchgear 200 and current paths from an individual power module 201, 202 and 203 of the medium voltage switchgear 200 to a load (e.g. to a main transformer 115) are not shown in Fig. 6. The solid lines originating from the input and output sensors of an individual power module indicate signal lines provided for transferring a current signal indicative of a current measured by the respective input or output current sensor to a processing means.

Fig. 6 is a block diagram of a fault detection device according to a typical embodiment. As shown in Fig. 6, the signals indicating the input currents are summed up in an input current sum determination unit 304 whereas the signals indicative of the output currents of the individual power modules are summed up in an output current sum determination unit 404. If no fault occurs (e.g. an open circuit, a short circuit, a ground fault, an insulation fault, a low-arc flash-based current, an electrical arc), the sum of the input currents 501, 502 and 503 (not shown in Fig. 6, see Fig. 5) should correspond to the sum of the output currents 601, 602 and 603 (not shown in Fig. 6, see Fig. 5).

A signal indicating the sum of the input currents into the individual power modules is output by the input current sum determination unit 304, whereas a signal indicating the sum of the output currents of the individual power modules 201, 202 and 203 is output by the output current sum determination unit 404. Both signals are fed to a comparator 405 which in turn provides a comparison of the sum of the input currents and the sum of the output currents.

The comparator 405 is connected to a control unit 406 which, based on the comparison in the comparator 405, outputs a control signal 407 to control at least one of the power modules 201, 202 and 203 or an entire medium voltage switchgear 200. The control signal 407 may control other electrical/electronic components in the electrical part of the wind turbine such that, once an electrical fault is detected, components may be e.g. switched off in order to avoid further electrical faults to happen.

The control unit may be adapted to provide a control signal for switching off a failed power module once an electrical fault has been detected at this respective power module. If absolute values of input and output currents are compared within the comparator 405, the fault detection device in accordance with the typical embodiment shown in Fig. 6 may include at least one of an input current sum determination unit 304 adapted for determining a current sum of the input currents of the power modules 201, 202 and 203 of the medium voltage switchgear, and an output current sum determination unit 404 adapted for determining a current sum of the output current 601, 602 and 603 of the individual power modules 201, 202 and 203 of the medium voltage switchgear 200.

The comparison performed at the comparator 405 furthermore may include a comparison of at least one output current with at least one input current with respect to its amplitude, a current rise time, a current fall time and a frequency. Furthermore, it is possible to analyze a time behaviour of the respective output current with respect to the respective input current of an individual power module 201, 202 and 203 and/or an entire medium voltage switchgear 200.

Furthermore it is possible, for an individual power module 201, 202 and 203 or for an entire medium voltage switchgear 200, to determine a margin which defines a maximum permissible deviation of the at least one output current 601, 602 and 603 from a respective at least one input current 501, 502 and 503. In accordance with the provision of a margin, a respective power module 201, 202 and 203 may be switched off, if the maximum permissible deviation margin for this respective power module has been exceeded. In addition to that, the respective power module 201, 202 and 203 may be switched off only, if the maximum permissible deviation margin for this power module 201, 202 and 203, respectively, is exceeded for a predetermined time duration.

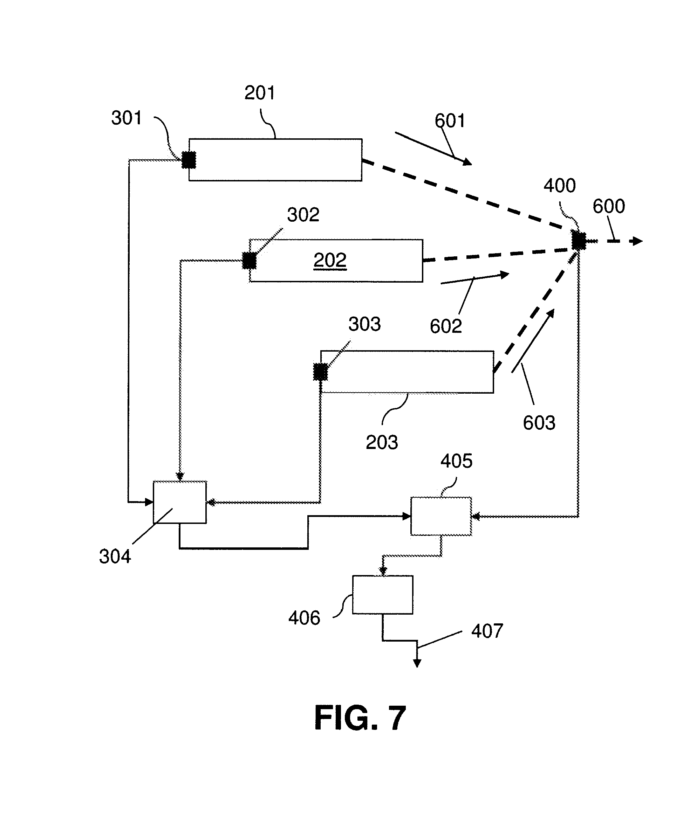

Fig. 7 is a block diagram of a fault detection device according to yet another typical embodiment. As shown in Fig. 7, again three power modules 201, 202 and 203 are provided wherein each power module has a respective input current sensor, i.e. the first power module 201 has a first input current sensor 301, the second power module 202 has a second input current sensor 302 and the third power module 203 has a third input current sensor 303.

In contrast to the block diagram shown in Fig. 6, however, the output currents of all three individual power modules 201, 202 and 203 are measured by means of a common output current sensor 400. This situation occurs, if the outputs of the individual power modules 201, 202 and 203 are connected to each other such that the output currents 601, 602 and 603 add up to a common output current 600 supplied to a load (not shown in Fig. 7).

It is noted here that the dashed bold lines correspond to currents paths (output current paths), wherein the thin solid lines correspond to signal lines carrying current signals indicating input and output currents, respectively. Thus, the common output current sensor 400 measures the sum of the output current 601, 602 and 603, wherein the sum of the input currents (current paths are not shown in Fig. 7) is determined by means of the input current sum determination unit 304, as described herein above with respect to Fig. 6.

The sum of the output currents again is compared to the sum of the input currents by means of a comparator 405, the output of which is connected to a control unit 406 in order to provide a control signal 407. The control signal 407 may then be used to provide additional measures in order to protect the electronic/electrical components of the wind turbine 101 once an electrical fault has been detected by means of the fault detection device in accordance with one of the typical embodiments.

As shown in Fig. 7, a single common output current sensor 400 for all power modules 201, 202 and 203 is combined with individual input currents sensors 301, 302 and 303 for the individual power modules 201, 202 and 203, in order to perform a comparison by means of the comparator 405. On the other hand, albeit not shown in Fig. 7, it is possible to provide a single common input current sensor for all power modules and to combine this common input current sensor with individual output current sensors 601, 602 and 603 for the individual power modules 201, 202 and 203, respectively. In addition to that it is possible to combine a single common output sensor 400 for all power modules with a single common input sensor for all power modules 201, 202 and 203 for performing the comparison.

Moreover, the fault detection device in accordance with a typical embodiment may include a phase shift determination unit adapted for determining a respective phase shift between the at least one output current 601, 602 and 603 of the at least one power module 201, 202 and 203 of the medium voltage switchgear 200 and the at least one input current 501, 502 and 503 of the at least one power module 201, 202 and 203 of the medium voltage switchgear 200.

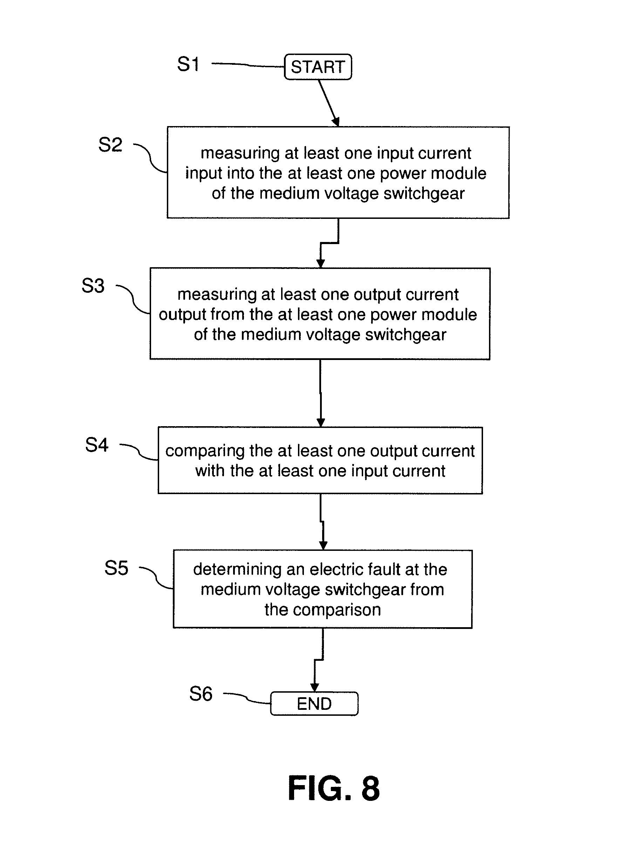

Fig. 8 is a flowchart illustrating a method for detecting an electrical fault at a medium voltage switchgear having at least one power module. The method starts at a step S1. At a step S2, at least one input current of the at least one power module of the medium voltage switchgear 200 is measured. Then, the procedure advances to a step S3, where at least one output current of the at least one power module of the medium voltage switchgear 200 is measured.

Then, at the following step S4, the at least one output current is compared with the at least one input current. The comparison of the at least one output current with the at least one input current may include at least one of a current amplitude comparison, a current rise time comparison, a current fall time comparison and a frequency comparison. Furthermore, a time behaviour of the output current with respect to the input current may be determined. On the basis of the determined time behaviour, it is possible to determine electrical faults within at least one power module 201, 202 and 203 of the medium voltage switchgear 200. In addition to that, the comparison may include the generation of at least one time derivative of the at least one input current and the output current.

Moreover, a margin will be determined which defines a maximum permissible deviation of the at least one output current from the at least one input current.

The procedure advances to a step S5 where an electrical fault at the medium voltage switchgear and/or an individual power module 201, 202 and 203 of the medium voltage switchgear 200 is determined from the comparison performed at the step S4 described above, e.g., a respective power module 201, 202 and 203 may be switched off, if a maximum permissible deviation margin for this power module is exceeded. In addition to that, the respective power module 201, 202 and 203 may be switched off only, if the maximum permissible deviation margin for this power module 201, 202 and 203, respectively, is exceeded for a predetermined time duration.

This written description uses examples to disclose the invention, including the preferred mode, and also to enable any person skilled in the art to practice the described subject-matter, including making and using any devices or systems and performing any incorporated methods. While various specific embodiments have been disclosed in the foregoing, those skilled in the art will recognize that the spirit and scope of the claims allows for equally effective modifications. Especially, mutually non-exclusive features of the embodiments described above may be combined with each other. The patentable scope is defmed by the claims, and may include such modifications and other examples that occur to those skilled in the art. Such other examples are intended to be within the scope of the claims if they have structural elements that do not differ from the literal language of the claims, or if they include equivalent structural elements with insubstantial differences from the literal language of the claims.

Various aspects and embodiments of the present invention are defined by the following numbered clauses:
1. A fault detection device adapted for detecting an electrical fault at a medium voltage switchgear having at least one power module, the fault detection device comprising:
   at least one input current sensor adapted for measuring at least one input current of the at least one power module of the medium voltage switchgear;
   at least one output current sensor adapted for measuring at least one output current of the at least one power module of the medium voltage switchgear;
   a comparator adapted for comparing the at least one output current with the at least one input current; and,
   a control unit adapted for determining an electrical fault at the at least one power module of the medium voltage switchgear on the basis of the comparison.
2. The fault detection device in accordance with clause 1 wherein the at least one input current sensor and/or the at least one output current sensor is selected from the group consisting of a Hall current sensor, a Faraday rotation sensor, a shunt, an inductive sensor, a current transformer, and any combination thereof.
3. The fault detection device in accordance with any preceding clause, further comprising a phase shift determination unit adapted for determining a respective phase shift between the at least one output current of the at least one power module of the medium voltage switchgear and the at least one input current of the at least one power module of the medium voltage switchgear.
4. The fault detection device in accordance with any preceding clause, wherein the control unit is adapted to provide a control signal for switching off a respective power module once an electrical fault has been detected at this power module.
5. The fault detection device in accordance with any preceding clause, further comprising at least one of an input current sum determination unit adapted for determining a current sum of the input currents of the power modules of the medium voltage switchgear, and an output current sum determination unit adapted for determining a current sum of the output currents of the power modules of the medium voltage switchgear.
6. The fault detection device in accordance with any preceding clause, wherein a single common output current sensor for all power modules is combined with individual input current sensors for individual power modules, for performing the comparison.
7. The fault detection device in accordance with any preceding clause, wherein a single common input current sensor for all power modules is combined with individual output current sensors for individual power modules, for performing the comparison.
8. The fault detection device in accordance with any preceding clause, wherein a single common output current sensor for all power modules is combined with a single common input current sensor for all power modules, for performing the comparison.
9. A wind turbine having an electrical generator adapted for converting mechanical energy into electrical energy, a medium voltage switchgear and a fault detection device adapted for detecting an electrical fault at the medium voltage switchgear, the fault detection device comprising:
   at least one input current sensor adapted for measuring at least one input current of the at least one power module of the medium voltage switchgear;
   at least one output current sensor adapted for measuring at least one output current of the at least one power module of the medium voltage switchgear;
   a comparator adapted for comparing the at least one output current with the at least one input current; and,
   a control unit adapted for determining an electrical fault at the at least one power module of the medium voltage switchgear from the comparison.
10. The wind turbine in accordance with any preceding clause, wherein the at least one input current sensor and/or the at least one output current sensor is provided as at least one of a Hall current sensor, a Faraday rotation sensor, a shunt, an inductive sensor, and a current transformer.
11. The wind turbine in accordance with any preceding clause, further comprising a phase shift determination unit adapted for determining a respective phase shift between the at least one output current of the at least one power module of the medium voltage switchgear and the at least one input current of the at least one power module of the medium voltage switchgear.
12. The wind turbine in accordance with any preceding clause, wherein the control unit is adapted to provide a control signal for switching off a respective power module once an electrical fault has been detected at this power module.
13. The wind turbine in accordance with any preceding clause, further comprising at least one of an input current sum determination unit adapted for determining a current sum of the input currents of the power modules of the medium voltage switchgear, and an output current sum determination unit adapted for determining a current sum of the output currents of the power modules of the medium voltage switchgear.
14. The wind turbine in accordance with any preceding clause, wherein a single common output current sensor for all power modules is combined with individual input current sensors for individual power modules, for performing the comparison.
15. The wind turbine in accordance with any preceding clause, wherein a single common input current sensor for all power modules is combined with individual output current sensors for individual power modules, for performing the comparison.
16. A method for detecting an electrical fault at a medium voltage switchgear having at least one power module, the method comprising:
   measuring at least one input current of the at least one power module of the medium voltage switchgear;
   measuring at least one output current of the at least one power module of the medium voltage switchgear;
   comparing the at least one output current with the at least one input current;
      and,
   determining an electrical fault at the medium voltage switchgear from the comparison.
17. The method in accordance with any preceding clause, wherein the comparison of the at least one output current with the at least one input current is selected from a group consisting of a current amplitude comparison, a current rise time comparison, a current fall time comparison, a frequency comparison, and any combination thereof.
18. The method in accordance with any preceding clause, wherein a margin is determined which defines a maximum permissible deviation of the at least one output current from the at least one input current.
19. The method in accordance with any preceding clause, wherein the respective power module is switched off if the maximum permissible deviation margin for this power module is exceeded for a predetermined time duration.
20. The method in accordance with any preceding clause, wherein the medium voltage switchgear is provided as a part of a wind turbine.

## Claims

1. A fault detection device adapted for detecting an electrical fault at a medium voltage switchgear (200) having at least one power module (201, 202, 203), the fault detection device comprising:
at least one input current sensor (301, 302, 303) adapted for measuring at least one input current (501, 502, 503) of the at least one power module (201, 202, 203) of the medium voltage switchgear (200);
at least one output current sensor (400, 401, 402, 403) adapted for measuring at least one output current (600, 601, 602, 603) of the at least one power module (201, 202, 203) of the medium voltage switchgear (200);
a comparator (405) adapted for comparing the at least one output current (600, 601, 602, 603) with the at least one input current (501, 502, 503); and
a control unit (406) adapted for determining an electrical fault at the at least one power module (201, 202, 203) of the medium voltage switchgear (200) on the basis of the comparison.

2. The fault detection device in accordance with claim 1, wherein the at least one input current sensor (301, 302, 303) and/or the at least one output current sensor (400, 401, 402, 403) is provided as at least one of a Hall current sensor, a Faraday rotation sensor, a shunt, an inductive sensor, and a current transformer.

3. The fault detection device in accordance with claim 1 or 2, further comprising a phase shift determination unit adapted for determining a respective phase shift between the at least one output current (600, 601, 602, 603) of the at least one power module (201, 202, 203) of the medium voltage switchgear (200) and the at least one input current (501, 502, 503) of the at least one power module (201, 202, 203) of the medium voltage switchgear (200).

4. The fault detection device in accordance with any one of the preceding claims, wherein the medium voltage switchgear (200) comprises a plurality of power modules (201, 202, 203).

5. The fault detection device in accordance with any one of the preceding claims, wherein the control unit (406) is adapted to provide a control signal for switching off a respective power module (201, 202, 203) once an electrical fault has been detected at this power module (201, 202, 203).

6. The fault detection device in accordance with any one of the preceding claims, further comprising at least one of an input current sum determination unit (304) adapted for determining a current sum of the input currents (501, 502, 503) of the power modules (201, 202, 203) of the medium voltage switchgear (200), and an output current sum determination unit (404) adapted for determining a current sum of the output currents of the power modules (201, 202, 203) of the medium voltage switchgear (200).

7. The fault detection device in accordance with any one of the preceding claims, wherein a single common input current sensor (301, 302, 303) for all power modules (201, 202, 203) is combined with individual output current sensors for individual power modules (201, 202, 203), for performing the comparison, and/or a single common output current sensor (400, 401, 402, 403) for all power modules (201, 202, 203) is combined with a single common input current sensor (301, 302, 303) for all power modules (201, 202, 203), for performing the comparison and/or a single common output current sensor (400, 401, 402, 403) for all power modules (201, 202, 203) is combined with individual input current sensors for individual power modules (201, 202, 203), for performing the comparison.

8. A method for detecting an electrical fault at a medium voltage switchgear (200) having at least one power module (201, 202, 203), the method comprising:
measuring at least one input current (501, 502, 503) of the at least one power module (201, 202, 203) of the medium voltage switchgear (200);
measuring at least one output current (600, 601, 602, 603) of the at least one power module (201, 202, 203) of the medium voltage switchgear (200);
comparing the at least one output current (600, 601, 602, 603) with the at least one input current (501, 502, 503); and
determining an electrical fault at the medium voltage switchgear (200) from the comparison.

9. The method in accordance with claim 8, wherein the comparison of the at least one output current (600, 601, 602, 603) with the at least one input current (501, 502, 503) is selected from the group consisting of a current amplitude comparison, a current rise time comparison, a current fall time comparison, a frequency comparison, a time behaviour of the output current (600, 601, 602, 603) with respect to the input current (501, 502, 503), and any combination thereof.

10. The method in accordance with claim 8 or 9, wherein a margin is determined which defines a maximum permissible deviation of the at least one output current (600, 601, 602, 603) from the at least one input current (501, 502, 503), and wherein the respective power module (201, 202, 203) is switched off if the maximum permissible deviation margin for this power module (201, 202, 203) is exceeded, or if the maximum permissible deviation margin for this power module (201, 202, 203) is exceeded for a predetermined time duration.
